# EUROPEAN PATENT APPLICATION

(11) **EP 4 366 142 A1**
(43) Date of publication of application: **08.05.2024**
(21) Application number: 22832161.8
(22) Date of filing: 30.06.2022
(51) Int. Cl.: H02K 11/33, H02K 9/19

(54) **ELECTRIC MOTOR INVERTER**

(30) Priority: 30.06.2021 CN 202121477518 U; 30.06.2021 CN 202110734469
(71) Applicant: Shanghai Valeo Automotive Electrical Systems Co., Ltd., Shanghai 201201 (CN)
(72) Inventor: WEI, Yubo, Shanghai 201201 (CN); QIAN, Zheng, Shanghai 201201 (CN); XU, Jin, Shanghai 201201 (CN); WANG, Jian, Shanghai 201201 (CN); LIU, Lei, Shanghai 201201 (CN); ZHANG, Yangyang, Shanghai 201201 (CN); WANG, Junhao, Shanghai 201201 (CN)
(74) Representative: Valeo Powertrain Systems
(86) International application number: PCT/CN2022/102656
(87) International publication number: WO 2023/274349

(57) **Abstract**

Disclosed in the present application is an electric motor inverter, comprising: a housing, a radiator, a power module, an energy storage module, a control board and a filter module, wherein the radiator is provided with a through hole, and the radiator is provided with a cooling water channel on an outer side of the through hole; the power module is arranged on one side of the radiator; the power module comprises three power boards, which are circumferentially arranged on the outer side of the through hole and respectively correspond to the cooling water channel in position; the filter module and the power module are arranged on the radiator and are adjacent to each other; the energy storage module is arranged on the other side of the radiator, and the energy storage module partially passes through the through hole and is then electrically connected to the three power boards and the filter module; the housing is connected to the radiator and covers the power module, the filter module and the energy storage module; the control board is arranged between the housing and the power module and is fixedly connected to the radiator on an inner side of the cooling water channel; and the control board is electrically connected to the power module, the filter module and the energy storage module. The electric motor inverter has the beneficial effects of a small size, a high heat dissipation efficiency and a long service life.

## Description

### TECHNICAL FIELD

The present application relates to the field of motor technology, and in particular to an electric motor inverter.

### BACKGROUND

Motor inverters are widely used power converters for vehicles. In recent years, there is an increasing use of integrated inverters. An integrated inverter integrates an inverter on the back cover of a motor, which can effectively save the installation space and reduce the size of the equipment. However, existing integrated inverters have the following technical problems during use: in existing integrated inverters, the power module and the energy storage capacitor are simply arranged side by side on the same side of the radiator, and the power module and the energy storage capacitor occupy a large installation space with low levels of integration, thus affecting the overall size of the motor to a certain extent. In addition, the radiator of an existing integrated inverter is only provided with a cooling water channel at the position of the power module, which cannot provide cooling and heat dissipation for heating components such as the control board and the energy storage module, thus affecting the service life of the inverter.

### SUMMARY

The purpose of the present application is to provide an electric motor inverter that is small in size and has high heat dissipation efficiency.

To achieve this purpose, the present application adopts the following technical solution:
An electric motor inverter, comprising: a housing, a radiator, a power module, an energy storage module, a control board and a filter module, wherein the radiator is provided with a through hole, the radiator is provided with a cooling water channel on an outer side of the through hole, the power module is arranged on one side of the radiator, the power module comprises three power boards, the three power boards are circumferentially arranged on the outer side of the through hole and respectively correspond to the position of the cooling water channel, the filter module and the power module are arranged on the radiator and are adjacent to each other, the energy storage module is arranged on another side of the radiator, a part of the energy storage module passes through the through hole, the part of the energy storage module passing through the through hole is electrically connected with the three power boards and the filter module respectively, the housing is connected with the radiator, the housing respectively covers the power module, the filter module and the part of the energy storage module passing through the through hole, the control board is arranged between the housing and the power module, the control board is fixedly connected with the radiator on the inner side of the cooling water channel, and the control board is electrically connected with the power module, the filter module and the energy storage module, respectively.

In one embodiment, the energy storage module comprises a plurality of energy storage capacitors, and the plurality of energy storage capacitors are arranged in a plurality of rows side by side.

In one embodiment, the electric motor inverter further comprises a phase current bracket, the phase current bracket is arranged between the control board and the power module, the phase current bracket comprises: a bracket body, electroconductive plates, ferromagnetic rings and rivet nuts, the bracket body comprises three interconnected bracket plates, the three bracket plates respectively correspond to the positions of the three power boards, each of the bracket plates is injection-molded with an electroconductive plate and a ferromagnetic ring, the electroconductive plate extends through the ferromagnetic ring to the outer side of the bracket plate, and the rivet nut is fixed on a corresponding electroconductive plate.

In one embodiment, the electric motor inverter further comprises a spring plate, the spring plate is arranged between the phase current bracket and the power module, the spring plate comprises a base plate and spring tabs arranged on the base plate, the base plate is arranged on the power module, and the spring tabs abut the phase current bracket.

In one embodiment, the electric motor inverter further comprises a signal connector, and the signal connector is arranged on the housing.

In one embodiment, the electric motor inverter further comprises a power connector, the power connector comprises a plastic body, a positive copper plate, a negative copper plate, a positive stud and a negative stud, the plastic body is connected with the radiator, the positive copper plate and the negative copper plate are both arranged on the plastic body, the positive stud is connected with the positive copper plate, the negative stud is connected with the negative copper plate, a circular anti-rotation wall is provided on the plastic body at a position corresponding to the positive stud, and a square anti-rotation wall is provided on the plastic body at a position corresponding to the negative stud.

In one embodiment, the electric motor inverter further comprises a breather valve, and the breather valve is arranged on the housing.

In one embodiment, the power module and the energy storage module are respectively bonded to the radiator by thermal conductive glue, and thermal conductive silicone grease is provided between the control board and the radiator.

In one embodiment, the radiator comprises a metal shell and a metal cover plate, a cooling water groove is provided on the metal shell, and the metal cover plate is welded to the metal shell at the cooling water groove.

In one embodiment, the electric motor inverter further comprises a rotation speed sensor connector, the rotation speed sensor connector is arranged on the radiator, and the rotation speed sensor connector is electrically connected with the control board.

In the electric motor inverter described above, the power module and the energy storage module are respectively arranged on the two sides of the radiator, the three power boards of the power module are arranged circumferentially on the outer side of the energy storage module, and the energy storage module and the power module are arranged in a circular layout from the inside to the outside, which can effectively save the installation space. The inverter is highly integrated, which can minimize the overall size of the motor and meet the development needs of motor miniaturization. In addition, in the electric motor inverter described above, the cooling water channel is designed to be arranged circumferentially on the outer side of the through hole, the three power boards respectively correspond to the position of the cooling water channel, the energy storage module is located on the inner side of the cooling water channel, and the control board is fixedly connected with the radiator on the inner side of the cooling water channel. Therefore, the cooling water channel can have a cooling effect on the power module, the energy storage module and the cooling water channel at the same time. The overall cooling and heat dissipation effect of the inverter is good, which is beneficial to extending the service life of the inverter. In view of the above, the electric motor inverter described above has the beneficial effects of a small size, high heat dissipation efficiency and a long service life.

### BRIEF DESCRIPTION OF THE DRAWINGS

FIG. 1 is a schematic structural diagram of the electric motor inverter in one embodiment;
FIG. 2 is an exploded view of the structure of the electric motor inverter in one embodiment;
FIG. 3 is a schematic structural diagram of the metal shall in one embodiment;
FIG. 4 is a schematic structural diagram showing how the radiator is respectively connected with the power module and energy storage module in one direction in one embodiment;
FIG. 5 is a schematic structural diagram showing how the radiator is respectively connected with the power module and energy storage module in another direction in one embodiment;
FIG. 6 is a schematic structural diagram of the phase current bracket in one embodiment;
FIG. 7 is a schematic structural diagram of the spring plate in one embodiment;
FIG. 8 is a schematic structural diagram of the power connector in one embodiment.

### Numerals in the drawings:

10 - housing, 20 - radiator, 30 - power module, 40 - energy storage module, 50 - control board, 60 - filter module, 70 - phase current bracket, 80 - spring plate, 90 - signal connector, 100 - power connector, 110 - breather valve, 120 - rotation speed sensor connector;

21 - cooling water channel, 22 - metal shell, 23 - metal cover plate, 31 - power board, 41 - energy storage capacitor, 71 - bracket body, 72 - electroconductive plate, 73 - ferromagnetic ring, 81 - base plate, 82 - spring tab, 83 - positioning hole, 101 - plastic body, 102 - circular anti-rotation wall, 103 - square anti-rotation wall, 104 - positive stud, and 105 - negative stud.

### DETAILED DESCRIPTION

The technical solution of the present application is explained further below by way of specific embodiments with reference to the drawings.

In the description of the present application, it should be understood that orientation or positional relationships indicated by the terms "up", "down", "front", "rear", "left", "right", "vertical", "horizontal", "top", "bottom", "inner" and "outer", etc. are based on the orientation or positional relationships shown in the accompanying drawings, and are merely intended to facilitate the description of the present application and simplify the description, rather than indicating or implying that the apparatus or element referred to must have a specific orientation or be constructed and operated in a specific orientation, and therefore should not be understood as limiting the present application.

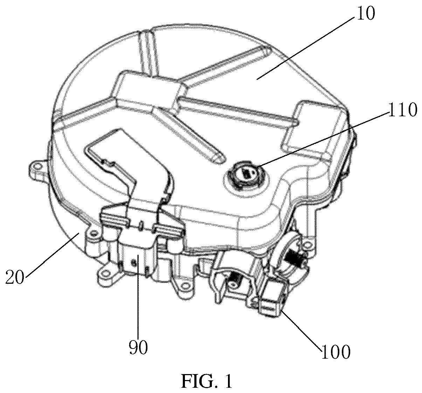

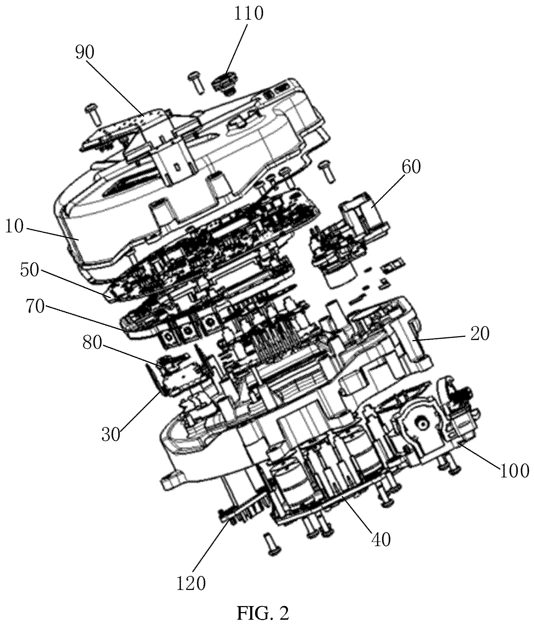

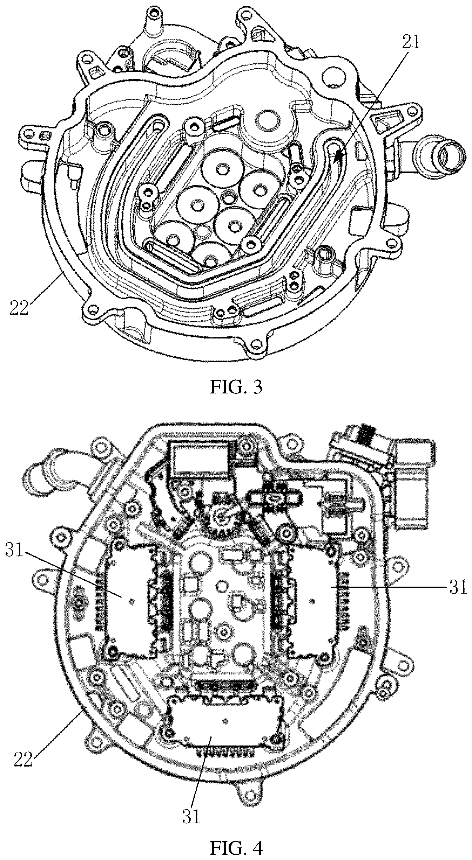

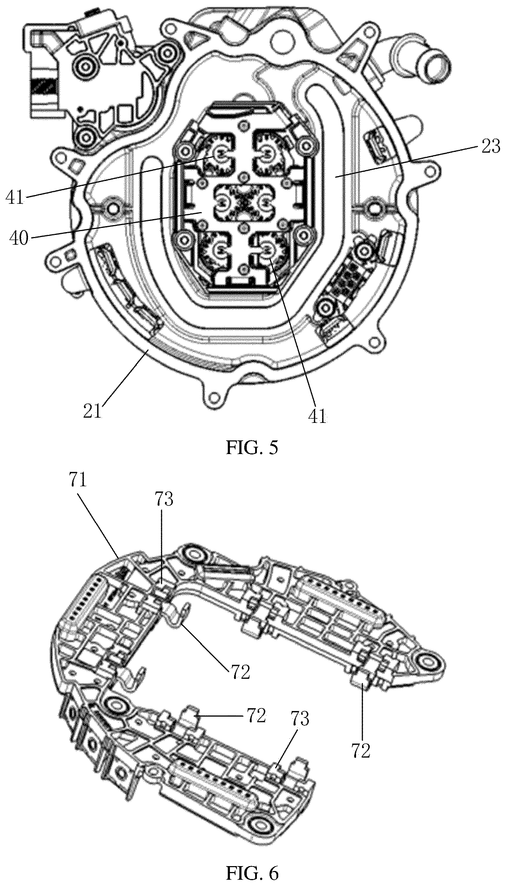

Referring to FIG. 1 to FIG. 8, the electric motor inverter of one embodiment comprises: a housing 10, a radiator 20, a power module 30, an energy storage module 40, a control board 50 and a filter module 60. The radiator 20 is provided with a through hole, the radiator 20 is provided with a cooling water channel 21 on the outer side of the through hole, the power module 30 is arranged on one side of the radiator 20, the power module 30 comprises three power boards 31, the three power boards 31 are circumferentially arranged on the outer side of the through hole and respectively correspond to the position of the cooling water channel 21, the filter module 60 and the power module 30 are arranged on the radiator 20 and are adjacent to each other, the energy storage module 40 is arranged on the other side of the radiator 20, a part of the energy storage module 40 passes through the through hole, the part of the energy storage module 40 passing through the through hole is electrically connected with the three power boards 31 and the filter module 60 respectively, the housing 10 is connected with the radiator 20, the housing 10 respectively covers the power module 30, the filter module 60 and the part of the energy storage module 40 passing through the through hole, the control board 50 is arranged between the housing 10 and the power module 30, the control board 50 is fixedly connected with the radiator 20 on the inner side of the cooling water channel 21, and the control board 50 is electrically connected with the power module 30, the filter module 60 and the energy storage module 40, respectively.

In the electric motor inverter described above, the power module 30 and the energy storage module 40 are respectively arranged on the two sides of the radiator 20, the three power boards 31 of the power module 30 are arranged circumferentially on the outer side of the energy storage module 40, and the energy storage module 40 and the power module 30 are arranged in a circular layout from the inside to the outside, which can effectively save the installation space. The inverter is highly integrated, which can minimize the overall size of the motor and meet the development needs of motor miniaturization. In addition, in the electric motor inverter described above, the cooling water channel 21 is designed to be arranged circumferentially on the outer side of the through hole, the three power boards 31 respectively correspond to the position of the cooling water channel 21, the energy storage module 40 is located on the inner side of the cooling water channel 21, and the control board 50 is fixedly connected with the radiator 20 on the inner side of the cooling water channel 21. Therefore, the cooling water channel 21 can have a cooling effect on the power module 30, the energy storage module 40 and the cooling water channel 21 at the same time. The overall cooling and heat dissipation effect of the inverter is good, which is beneficial to extending the service life of the inverter. The electric motor inverter described above has the beneficial effects of a small size, high heat dissipation efficiency and a long service life.

In one embodiment, the energy storage module 40 comprises a plurality of energy storage capacitors 41, and the plurality of energy storage capacitors 41 are arranged in a plurality of rows side by side. In this embodiment, the energy storage module 40 comprises six energy storage capacitors 41, and the six energy storage capacitors 41 are arranged in two rows of three side by side. Compared with the conventional structure in which a plurality of energy storage capacitors 41 are arranged in a single row, the plurality of energy storage capacitors 41 are arranged in a plurality of rows side by side, which can reduce the row length of the energy storage capacitors 41, thereby effectively reducing the diameter of the inverter and making it possible to arrange the energy storage capacitors 41 at the center of the inverter. The circular layout of the power module 30 around the energy storage capacitors 41 minimizes the size of the inverter. Further, in this embodiment, the three power boards 31 are arranged around the energy storage module 40 at an angle of 270 degrees. Adjacent power boards 31 are arranged perpendicular to each other. The three power boards 31 are evenly distributed around the energy storage module 40. The capacitance value can be evenly distributed on each power board 31, and the filtering effect is good.

In one embodiment, the electric motor inverter further comprises a phase current bracket 70, the phase current bracket 70 is arranged between the control board 50 and the power module 30, the phase current bracket 70 comprises: a bracket body 71, electroconductive plates 72, ferromagnetic rings 73 and rivet nuts, the bracket body 71 comprises three interconnected bracket plates, the three bracket plates respectively correspond to the positions of the three power boards 31, each of the bracket plates is injection-molded with an electroconductive plate 72 and a ferromagnetic ring 73, the electroconductive plate 72 extends through the ferromagnetic ring 73 to the outer side of the bracket plate, and the rivet nut is fixed on a corresponding electroconductive plate 72. Specifically, the phase current bracket 70 is electrically connected with the motor phase line and the power module 30 respectively and is used to correct the position of the terminal of the power module 30 and collect the magnetic flux generated by the phase current. of them, the bracket body 71 is used to provide supporting and insulation and to guide and position the terminals on the power module 30. The rivet nuts are respectively connected with the motor phase wires and the electroconductive plates 72. The electroconductive plates 72 are used to conduct current, and the ferromagnetic rings 73 are used to concentrate the magnetic field generated by the phase current. Both the electroconductive plates 72 and the ferromagnetic rings 73 are injection-molded in the corresponding bracket plate. Further, in this embodiment, the layout of the three bracket plates of the bracket body 71 corresponds to the layout of the three power boards 31 of the power module 30. The bracket body 71 is also arranged around the through hole, so that a passage is formed above the through hole for the heating elements on the control board 50 to pass through, the heating elements on the control board 50 can pass through the passage and connect to the radiator 20 on the outer side of the cooling water channel 21, and that the radiator 20 can cool and dissipate heat of the heating elements on the control board 50.

In one embodiment, the electric motor inverter further comprises a spring plate 80, the spring plate 80 is arranged between the phase current bracket 70 and the power module 30, the spring plate 80 comprises a base plate 81 and spring tabs 82 arranged on the base plate 81, the base plate 81 is arranged on the power module 30, and the spring tabs 82 abut the phase current bracket 70. Specifically, three spring plates 80 are provided, the three spring plates 80 are respectively arranged between the corresponding power board 31 and bracket plate, positioning holes 83 are provided on the base plate 81, positioning studs are provided at the corresponding positions on the radiator 20, through holes are provided at corresponding positions on the power boards 31, the positioning stud passes through the through hole and is inserted into the positioning hole 83, the base plate 81 fixes the power board 31 on the radiator 20 through the positioning hole 83 and the positioning stud, one end of the spring tab 82 is connected with the base plate 81, the other end abuts the bracket plate, and the spring tab 82 is compressed by the bracket plate and deforms to produce a pressing force and tightly presses the power board 31 through the base plate 81, thereby ensuring stable and reliable installation of the power board 31. Generally, epoxy resin is commonly used as the plastic-coated material of the power module 30, which is relatively brittle. Conventionally, the power module 30 is fixed on the radiator 20 by screws. This fixing method requires drilling on the power board 31, which easily causes cracking in the power board 31. In this embodiment, by setting the spring plate 80 to press the power board 31 to install and fix the power module 30, there is no need to drill holes on the power board 31, which can prevent cracking in the power board 31 and improve the structural stability of the power board 31. In addition, the spring plate tightly presses the power board 31 through the base plate 81, the contact area between the base plate 81 and the power board 31 is large, and the power board 31 is evenly stressed, which can prevent cracking in the power board 31 due to concentrated stress and further improve the structural stability of the power board 31. Moreover, by use of the spring plate 80 instead of the screw fixing structure, there is no need to reserve screw holes in the wall thickness above the cooling water channel 21 of the radiator 20, which helps to reduce the thermal resistance of the cooling water channel 21 and further improves the heat dissipation effect. Further, in one embodiment, the spring plate 80 is formed by a stamping process, which is a simple process at low costs.

In one embodiment, the electric motor inverter further comprises a signal connector 90 used to connect the signal current harness of the whole vehicle, and the signal connector 90 is arranged on the housing 10.

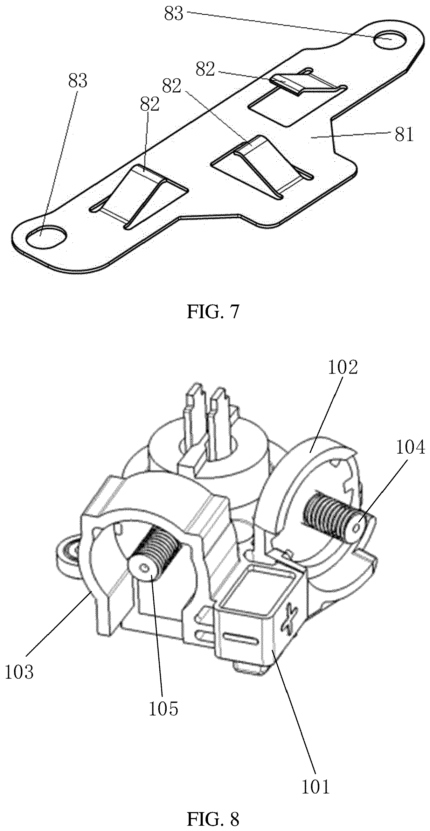

In one embodiment, the electric motor inverter further comprises a power connector 100 used for electrical connection between the inverter and the vehicle wiring harness. The power connector 100 is connected with the vehicle power supply current wiring harness and the filter module 60, respectively. As shown in FIG. 8, the power connector 100 comprises a plastic body 101, a positive copper plate, a negative copper plate, a positive stud 104 and a negative stud 105, the plastic body 101 is connected with the radiator 20, the positive copper plate and the negative copper plate are both arranged on the plastic body 101, the positive stud 104 is connected with the positive copper plate, the negative stud 105 is connected with the negative copper plate, a circular anti-rotation wall 103 is provided on the plastic body 101 at a position corresponding to the positive stud 104, and a square anti-rotation wall 104 is provided on the plastic body 101 at a position corresponding to the negative stud 105. Specifically, the plastic body 101 is used to provide support, insulation and installation positioning. In this embodiment, a circular anti-rotation wall 103 is provided on the plastic body 101 at a position corresponding to the positive stud 104, and a square anti-rotation wall 104 is provided on the plastic body 101 at a position corresponding to the negative stud 105. The circular anti-rotation wall 103 only cooperates with a circular plug, and the square anti-rotation wall 104 only cooperates with a square plug, thereby providing an error-proofing effect and helping to improve assembly efficiency. In addition, the plastic body 101 is also provided with through holes, and the plastic body 101 is fixed on the radiator 20 through the through holes using fastening bolts, making the installation and fixing stable and reliable. Further, a washer is provided at the through hole, and the washer can withstand the tightening force of the installation screw, further improving the installation stability.

In one embodiment, the electric motor inverter further comprises a breather valve 110, the breather valve 110 is provided on the housing 10, and the breather valve 110 can adjust the air pressure inside and outside the inverter to ensure the stability of the internal pressure of the inverter.

In one embodiment, to further improve the heat dissipation and cooling effect of the inverter, the power module 30 and the energy storage module 40 are respectively bonded to the radiator 20 by thermal conductive glue, and thermal conductive silicone grease is provided between the control board 50 and the radiator 20.

In one embodiment, the radiator 20 comprises a metal shell 22 and a metal cover plate 23, a cooling water groove is provided on the metal shell 22, and the metal cover plate 23 is welded to the metal shell 22 at the cooling water groove. Specifically, the metal cover plate 23 covers the cooling water groove to form a cooling water channel 21, the cooling water channel 21 has a water inlet and a water outlet, and the cooling water groove may be, but is not limited to, a U-shaped groove. A groove is directly made on the metal shell 22 to form a cooling water groove, and then a metal cover plate 23 is used to cover the cooling water groove to form a cooling water channel 21, which is an easy process that helps to save the molding costs. Further, the metal cover plate 23 is welded to the metal shell 22, which is an easy process at low costs.

In one embodiment, the electric motor inverter further comprises a rotation speed sensor connector 120, the rotation speed sensor connector 120 is arranged on the radiator 20, and the rotation speed sensor connector 120 is electrically connected with the control board 50. Specifically, the rotation speed sensor connector 120 is connected with a motor speed sensor signal harness for detecting the rotational speed of the motor rotor. In other embodiments, a motor speed sensor may also be directly provided on the radiator 20 instead of the rotation speed sensor connector 120, which is not specifically limited in this embodiment.

The technical features in the embodiments above may be combined arbitrarily, but for conciseness of description, not all of the possible combinations of the technical features in the embodiments above have been described. However, as long as a combination of these technical features does not involve contradiction, it should be regarded as falling into the scope of disclosure herein.

The embodiments above only present a few embodiments of the present application, and are described in a specific and detailed manner, but should not therefore be construed as limiting the scope of the patent application. It should be pointed out that without departing from the concept of the present application, a person skilled in the art could still make changes and improvements, all of which are included in the scope of protection of the present application. Thus, the scope of patent protection of the present application shall be defined by the attached claims.

## Claims

1. An electric motor inverter, comprising: a housing (10), a radiator (20), a power module (30), an energy storage module (40), a control board (50) and a filter module (60), wherein the radiator (20) is provided with a through hole, the radiator (20) is provided with a cooling water channel (21) on an outer side of the through hole, the power module (30) is arranged on one side of the radiator (20), the power module (30) comprises three power boards (31), the three power boards (31) are circumferentially arranged on the outer side of the through hole and respectively correspond to a position of the cooling water channel (21), the filter module (60) is provided adjacent to the power module (30) on the radiator (20), the energy storage module (40) is arranged on the other side of the radiator (20), a part of the energy storage module (40) passes through the through hole, the part of the energy storage module (40) passing through the through hole is electrically connected with the three power boards (31) and the filter module (60) respectively, the housing (10) is connected with the radiator (20), the housing (10) covers the power module (30), the filter module (60) and the part of the energy storage module (40) passing through the through hole respectively, the control board (50) is arranged between the housing (10) and the power module (30), the control board (50) is fixedly connected with the radiator (20) on an inner side of the cooling water channel (21), and the control board (50) is electrically connected with the power module (30), the filter module (60) and the energy storage module (40) respectively.

2. The electric motor inverter according to claim 1, wherein the energy storage module (40) comprises a plurality of energy storage capacitors (41), and the plurality of energy storage capacitors (41) are arranged in a plurality of rows side by side.

3. The electric motor inverter according to claim 1, further comprising a phase current bracket (70), the phase current bracket (70) is arranged between the control board (50) and the power module (30), the phase current bracket (70) comprises: a bracket body (71), electroconductive plates (72), ferromagnetic rings (73) and rivet nuts, the bracket body (71) comprises three interconnected bracket plates, the three bracket plates respectively correspond to positions of the three power boards (31), each of the bracket plates is injection-molded with an electroconductive plate (72) and a ferromagnetic ring (73), the electroconductive plates (72) extend through the ferromagnetic rings (73) to an outer side of the bracket plate, and the rivet nuts are fixed on a corresponding electroconductive plate (72).

4. The electric motor inverter according to claim 3, further comprising a spring plate (80), wherein the spring plate (80) is arranged between the phase current bracket (70) and the power module (30), the spring plate (80) comprises a base plate (81) and spring tabs (82) arranged on the base plate (81), the base plate (81) is arranged on the power module (30), and the spring tabs (82) abut the phase current bracket (70).

5. The electric motor inverter according to claim 1, further comprising a signal connector (90), wherein the signal connector (90) is arranged on the housing (10).

6. The electric motor inverter according to claim 1, further comprising a power connector (100), wherein the power connector (100) comprises a plastic body (101), a positive copper plate, a negative copper plate, a positive stud (104) and a negative stud (105), the plastic body (101) is connected with the radiator (20), the positive copper plate and the negative copper plate are both arranged on the plastic body (101), the positive stud (104) is connected with the positive copper plate, the negative stud (105) is connected with the negative copper plate, a circular anti-rotation wall (103) is provided on the plastic body (101) at a position corresponding to the positive stud (104), and a square anti-rotation wall (104) is provided on the plastic body (101) at a position corresponding to the negative stud (105).

7. The electric motor inverter according to claim 1, further comprising a breather valve (110), wherein the breather valve (110) is arranged on the housing (10).

8. The electric motor inverter according to claim 1, wherein the power module (30) and the energy storage module (40) are respectively bonded to the radiator (20) by thermal conductive glue, and thermal conductive silicone grease is provided between the control board (50) and the radiator (20).

9. The electric motor inverter according to claim 1, wherein the radiator (20) comprises a metal shell (22) and a metal cover plate (23), a cooling water groove is provided on the metal shell (22), and the metal cover plate (23) is welded to the metal shell (22) at the cooling water groove.

10. The electric motor inverter according to claim 1, further comprising a rotation speed sensor connector (120), wherein the rotation speed sensor connector (120) is arranged on the radiator (20), and the rotation speed sensor connector (120) is electrically connected with the control board (50).
